Europäisches Patentamt

European Patent Office

Office européen des brevets

(11) Publication number:

**0 073 608**
**B1**

(12) **EUROPEAN PATENT SPECIFICATION**

(45) Date of publication of patent specification: **13.01.88**

(51) Int. Cl.⁴: **H 01 L 27/02, H 01 L 21/82**

(21) Application number: **82304368.2**

(22) Date of filing: **18.08.82**

(54) **Masterslice integrated circuit device and method for manufacturing the same.**

(30) Priority: **18.08.81 JP 129153/81**

(43) Date of publication of application:
**09.03.83 Bulletin 83/10**

(45) Publication of the grant of the patent:
**13.01.88 Bulletin 88/02**

(84) Designated Contracting States:
**DE FR GB**

(56) References cited:
**EP-A-0 029 369**
**US-A-3 999 080**

**IBM TECHNICAL DISCLOSURE BULLETIN,
volume 20, no. 9, February 1978, pages 3507-
3508, US; M. VERHAEGHE: "General purpose
master slice"**

**IBM TECHNICAL DISCLOSURE BULLETIN,
volume 21. no. 9, February 1979, pages 3655-
3656, US; Y. BONNET: "Connection of PNP
transistors in master slices"**

(73) Proprietor: **FUJITSU LIMITED**
**1015, Kamikodanaka Nakahara-ku**
**Kawasaki-shi Kanagawa 211 (JP)**

(72) Inventor: **Omichi, Hitoshi**
**Dai-2-Taihei-so, 203 Shukugawara**
**Tama-ku Kawasaki-shi Kanagawa 214 (JP)**
Inventor: **Tanizawa, Tetsu**
**Dai-2-Yurigaoka-ryo 2-7-5, Chiyogaoka**
**Asao-ku Kawasaki-shi Kanagawa 215 (JP)**
Inventor: **Mitono, Yoshiharu**
**1-14-12, Sakuragaoka**
**Setagaya-ku Tokyo 156 (JP)**

(74) Representative: **Fane, Christopher Robin King
et al
HASELTINE LAKE & CO. Hazlitt House 28
Southampton Buildings Chancery Lane
London, WC2A 1AT (GB)**

(56) References cited:
**AEROSPACE TECHNOLOGY, volume 21, no. 16,
January 1968, pages 30-46; "All major firms
watching developments"**

Courier Press, Leamington Spa, England.

# Description

The present invention relates to a masterslice integrated circuit device. More particularly, it relates to a semiconductor device having a large number of input/output buffers and a logic gate array and to a method for manufacturing the same by using masterslice technology.

In general, in a large-scale integrated (LSI) semiconductor circuit of complex logic, customers may request a preferred design. Therefore, when designers design logic LSI layout patterns in accordance with the customers' requirements, the design time becomes remarkably long, and, therefore, the manufacturing cost of logic LSI semiconductor circuits becomes high.

Therefore, for logic LSIs, it is essential to use a standard layout pattern so as to shorten the design time and lower the manufacturing cost. Several approaches have been taken to meet this requirement. One approach is masterslice (gate array) technology in which a standard layout pattern mainly for active areas and a custom-made layout pattern mainly for interconnections are prepared and merged into mask patterns for designing masks.

On the other hand, in an internal circuit of a logic LSI semiconductor device, a signal is transmitted by a small driving power and a small signal amplitude to enhance the operation speed. However, when a signal is transmitted from the internal circuit of the logic LSI semiconductor device to an external circuit outside the logic LSI semiconductor device, a large driving power is necessary. In addition, when there is a difference in the signal level between the internal circuit and the external circuit, level conversion is also necessary. For this purpose, a large number of input output buffers are provided on the perimeter of the logic LSI semiconductor device. Of course, such buffers are also manufactured by using masterslice technology.

In a prior art method for a semiconductor device having a large number of buffers, a plurality of buffer patterns are prepared as a standard layout pattern. In this case, each buffer pattern has a definite number of inputs and a definite number of outputs. For example, each buffer pattern has three inputs and one output. Next, a custom-made layout pattern is prepared for interconnections between the internal circuit and the inputs of each buffer.

In the above-mentioned prior art, however, since each buffer pattern has a definite number of inputs, the number of connection configurations between the internal circuit and the buffers is limited.

It is desirable to provide a masterslice integrated circuit device having a large number of input/output buffers and to provide a method for manufacturing the same by using masterslice technology in which the number of connection configurations between the internal circuit and the buffers is increased.

According to one aspect of the present invention, there is provided a masterslice integrated circuit device including a plurality of input and output logic gates disposed in a peripheral region thereof, a plurality of internal logic gates disposed in a central region thereof, and a custom-made wiring pattern disposed between the logic gates to desired function, the logic gates being arranged in the form of an array, at least one of the logic gates comprising: a plurality of PNP transistors each of the PNP transistors having a base for receiving a first signal and an emitter for providing a second signal corresponding to the first signal; and a plurality of output stage circuits which are arranged at positions so that at least one of the PNP transistors can be connected to one of the output stage circuits by the custom-made wiring pattern, one of the output stage circuits being connected to the emitter of at least one of the plurality of PNP transistors to form one of the logic gates.

According to a second aspect of the present invention, there is provided a method for manufacturing a masterslice integrated circuit device including a plurality of input and output logic gates disposed in a peripheral region thereof, a plurality of internal logic gates disposed in a central region thereof, and a custom-made wiring pattern disposed between the logic gates to desired function, the logic gates being arranged in the form of an array, the method comprising the steps of: forming a plurality of PNP transistors, each of the PNP transistors having a base for receiving a first signal and an emitter for providing a second signal corresponding to the first signal; forming a plurality of output stage circuits at positions so that at least one of the PNP transistors can be connected to one of the output stage circuits, each of the plurality of output stage circuits having an input and an output terminals; and electrically connecting the emitter of at least one of the plurality of PNP transistors to the input terminal of one of the plurality of output stage circuits to form one of the logic gates.

Reference will now be made, by way of example to the accompanying drawings, wherein

Fig. 1 is an equivalent circuit diagram illustrating a prior art masterslice integrated circuit device manufactured by using masterslice technology;

Fig. 2 is a logic circuit diagram of the circuit of Fig. 1;

Fig. 3 is an equivalent circuit diagram illustrating an embodiment of a masterslice integrated circuit device embodying the present invention;

Figs. 4A through 4D are logic circuit diagrams of the circuit of Fig. 3;

Fig. 5 is a circuit diagram in which the circuit of Fig. 1 is used as an output buffer of a logic LSI gate array;

Fig. 6 is a circuit diagram in which the circuit of Fig. 3 is used as an output buffer of a logic LSI gate array;

Figs. 7A and 7B are cross-sectional views illustrating NPN and PNP transistors; and

Fig. 8 is a plane view of an output buffer of Fig. 4A.

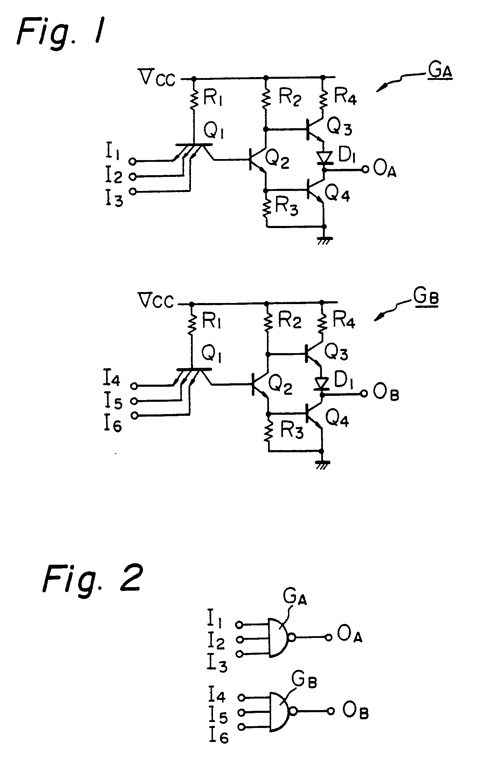

In Fig. 1, $G_A$ and $G_B$ designate buffer patterns constructed as transistor-transistor logic (TTL) patterns. Each buffer pattern $G_A$ and $G_B$ comprises resistors $R_1$ through $R_4$, transistors $Q_1$ through $Q_4$, and a diode $D_1$ to form a three-input NAND circuit. The transistor $Q_1$ is a multiemitter transistor having three emitters. The transistor $Q_2$ serves as an inverter. The transistors $Q_3$ and $Q_4$ form an output stage. That is, when one of the transistors $Q_3$ and $Q_4$ is turned on, the other is turned off.

The standard layout pattern represented by the buffer patterns $G_A$ and $G_B$ is connected to an internal circuit (not shown) by a custom-made layout pattern for interconnections. That is, inputs $I_1$, $I_2$, ..., $I_6$ of the buffer patterns $G_A$ and $G_B$ are connected selectively to logic gates of the internal circuit.

Note that, generally, in a masterslice integrated circuit device, a plurality of such input and output buffers which are also logic gates are arranged in a peripheral region, while a plurality of such internal logic gates are arranged in a central region. In addition, both types of the logic gates are arranged in the form of an array.

In the buffer pattern $G_A$, when at least one of the inputs $I_1$, $I_2$, and $I_3$ is at a low potential, a current flows from the power supply $V_{CC}$ through the resistor $R_1$ and the base and emitter of the transistor $Q_1$ to the internal circuit. As a result, the transistor $Q_2$ is turned off, and, accordingly, the transistors $Q_3$ and $Q_4$ are turned off and on, respectively, so as to cause the output $O_A$ to be at a high potential. Contrary to this, when all the inputs $I_1$ through $I_3$ are at a high potential, a current flows from the power supply $V_{CC}$ through the base and collector of the transistor $Q_1$ to the base of the transistor $Q_2$. As a result, the transistor $Q_2$ is turned on, and, accordingly, the transistors $Q_3$ and $Q_4$ are turned off and on, respectively, so as to cause the output $O_A$ to be at a low potential.

In Fig. 1, however, since the buffer pattern $G_A$ or $G_B$ has a definite number of inputs, such as three inputs, the number of connection configurations between the internal circuit and the inputs of the buffers is limited. For example, as illustrated in Fig. 2, which is a logic circuit of the buffer patterns $G_A$ and $G_B$ of Fig. 1, each of the inputs $I_1$ through $I_6$ is connected to one logic gate of the internal circuit (not shown). In addition, if only one logic gate of the internal circuit is connected to the buffer pattern $G_A$ by a custom-made layout pattern, only one input, such as the input $I_1$, is used while the other inputs $I_2$ and $I_3$ are unused. Therefore, wasted areas are created. Further, if four logic gates of the internal circuit are connected to the buffer pattern $G_A$ by a custom-made layout pattern, another kind of transistor $Q_1$ must be prepared and must be connected by the custom-made layout pattern to the buffer pattern $G_A$, and this procedure becomes complex.

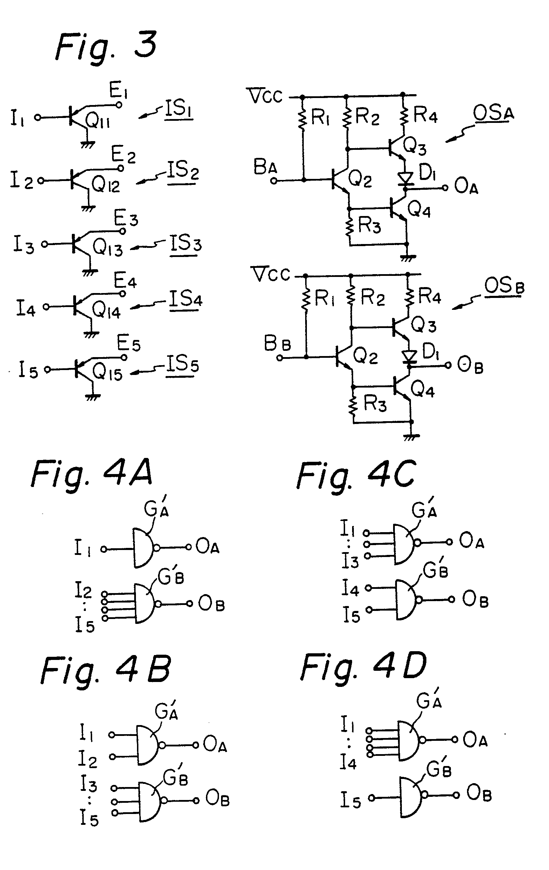

In Fig. 3, which illustrates an embodiment of the present invention, as a standard layout pattern for buffers which are, in this case, output buffers, two kinds of patterns are prepared. That is, a plurality of input stage patterns $IS_1$, $IS_2$, ..., $IS_5$ are regularly arranged and a plurality of output stage patterns $OS_A$ and $OS_B$ are regularly arranged. The input stage patterns are connected by a custom-made layout pattern (not shown) to the output stage patterns $OS_A$ and $OS_B$ so as to form output buffers.

Each input stage pattern, such as the $IS_1$, comprises a PNP transistor $Q_{11}$ having a base for an input $I_1$, an emitter for an output, and a grounded collector. On the other hand, each output stage pattern, such as the $OS_A$, comprises NPN transistors $Q_2$, $Q_3$, and $Q_4$, resistors $R_1$, $R_2$, $R_3$, and $R_4$, and a diode $D_1$. That is, the PNP transistors $Q_{11}$ through $Q_{15}$ correspond to the transistor $Q_1$ of Fig. 1.

Note that in Fig. 1 the transistors are all of the NPN type while in Fig. 3 each input stage pattern comprises a PNP transistor and each output stage pattern comprises NPN transistors.

A custom-made layout pattern is provided to selectively connect the emitters $E_1$ through $E_5$ of the input stage patterns to the bases $B_A$ and $B_B$ of the output stage patterns. Various configurations of the buffers $G_A'$ and $G_B'$ are realized. For example, when the emitter $E_1$ is connected to the base $B_A$ while the emitters $E_2$ through $E_5$ are connected to the base $B_B$, the buffer $G_A'$ serves as an inverter while the gate $G_B'$ serves as a four-input NAND circuit, as illustrated in Fig. 4A. When the emitters $E_1$ and $E_2$ are connected to the base $B_A$ while the emitters $E_3$, $E_4$, and $E_5$ are connected to the base $B_B$, the gate $G_A'$ serves as a two-input NAND circuit while the gate $G_B'$ serves as a three-input NAND circuit, as illustrated in Fig. 4B. When the emitters $E_1$, $E_2$, and $E_3$ are connected to the base $B_A$ while the emitters $E_4$ and $E_5$ are connected to the base $B_B$, the gate $G_A'$ serves as a three-input NAND circuit while the gate $G_B'$ serves as a two-input NAND circuit, as illustrated in Fig. 4C. When the emitters $E_1$ through $E_4$ are connected to the base $B_A$ while the emitter $E_5$ is connected to the base $B_B$, the gate $G_A'$ serves as a two-input NAND circuit while the gate $G_B'$ serves as an inverter, as illustrated in Fig. 4D. The number of configurations of the buffers $G_A'$ and $G_B'$ is increased by increasing the number of input stage patterns or PNP transistors.

Thus, in an embodiment of the present invention, it is possible to increase the degree of freedom regarding the number of inputs as compared with some prior devices.

In the circuit of Fig. 3, when the emitters $E_1$ and $E_2$ of the transistors $Q_{11}$ and $Q_{12}$ are connected to the base $B_A$ of the transistor $Q_2$ of the output stage pattern $OS_A$, a two-input NAND circuit $G_A'$ is realized, as illustrated in Fig. 4B. Therefore, when at least one of the inputs $I_1$ and $I_2$ is at a low potential, the output $O_A$ is at a high potential. That is, when the input $I_1$ is at a low potential, the transistor $Q_{11}$ is turned on. As a result, most of the current flowing through the resistor $R_1$ flows into the emitter and collector of the transistor $Q_{11}$, and, accordingly, the transistor $Q_2$ is turned off so as to turn on the transistor $Q_3$ and turn off the transistor

$Q_4$. Therefore, the output $O_A$ is at a high potential. On the other hand, when both of the inputs $I_1$ and $I_2$ are at a high potential, the transistors $Q_{11}$ and $Q_{12}$ are turned off so that most of the current flowing through the resistor $R_1$ flows into the base emitter of the transistor $Q_2$. Accordingly, the transistor $Q_2$ is turned on so as to turn off the transistor $Q_3$ and turn on the transistor $Q_4$. Therefore, the output $O_A$ is at a low potential and thus NAND logic operation is performed.

When the input $I_1$ is at a low potential, the base current flowing through the emitter base of the transistor $Q_{11}$ is $1/h_{FE}$ of the collector current flowing through the emitter and collector of the transistor $Q_{11}$. Therefore, this base current is very small, which means that the driving power of the internal circuit of the NAND circuit $G_A'$ can be small. That is, the fan-out (the number of outputs) of the internal circuit can be increased.

In Fig. 3, even if all the transistors $Q_{11}$ through $Q_{15}$ are replaced by diodes, various configurations of buffers as illustrated in Figs. 4A through 4D can be obtained by a custom-made layout pattern. In this case, however, when an input or a cathode of one diode is at a low potential, the current flowing through the resistor $R_1$ flows through the diode into the internal circuit, thereby decreasing the fan-out, or the number of outputs of the internal circuit.

In Fig. 3, if $Q_{11}$ through $Q_{15}$ are NPN transistors formed in individual isolated regions of a semiconductor device and each NPN transistor has a collector selectively connected to the base $B_A$ or the base $B_B$, a base for an input, and a grounded emitter, the buffers $G_A'$ and $G_B'$ serve as OR circuits, not as NAND circuits. If such individual NPN transistors are used for a NAND logic, it is necessary that the base of each transistor be connected by a connection to the resistor $R_1$ and that the collector of each transistor be connected by a connection to the base $B_A$. As a result, the connections become complex, and, in addition, the collector capacity can become large. Contrary to this, in embodiments of the invention, the collector of each PNP transistor is commonly grounded, and therefore the collector capacity can be kept small.

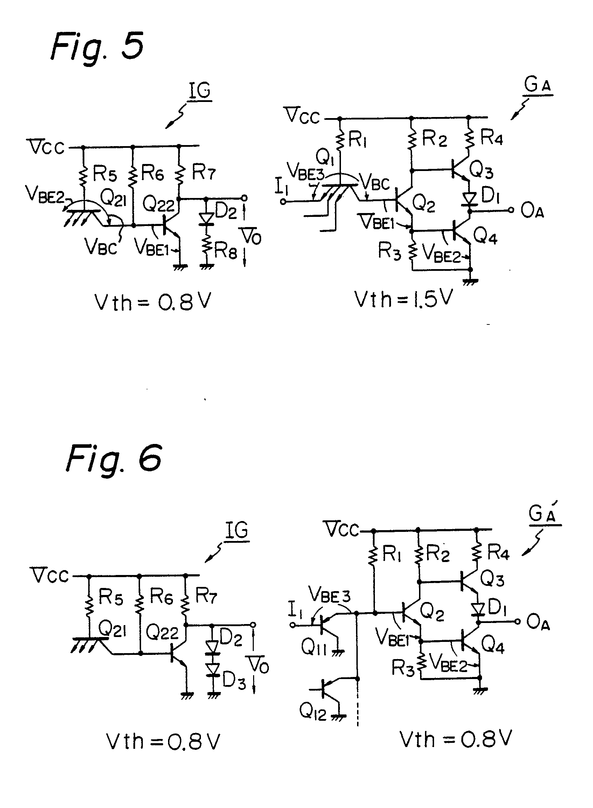

In Fig. 5, the buffer pattern $G_A$ of Fig. 1 is connected to an internal logic gate IG of an internal circuit. The logic gate IG is also constructed as a TTL circuit comprising transistors $Q_{21}$ and $Q_{22}$, resistors $R_5$, $R_6$, $R_7$, and $R_8$, and a diode $D_2$. In this case, the diode $D_2$ and the resistor $R_8$ form a clamp circuit for clamping the high level of the output voltage $V_0$.

In the buffer pattern $G_A$, the threshold voltage $V_{th}$ of the input $I_1$ is represented by:

$$V_{th}=V_{BC}+V_{BE1}+V_{BE2}-V_{BE3}$$

where $V_{BC}$ is the base to collector voltage of the transistor $Q_1$; $V_{BE1}$ is the base to emitter voltage of the transistor $Q_2$; $V_{BE2}$ is the base to emitter voltage of the transistor $Q_4$; and $V_{BE3}$ is the base to emitter voltage of the transistor $Q_1$. If it is assumed that $V_{BE1}{\cong}V_{BE2}{\cong}V_{BE3}$ $V_{BE}{\cong}0.8V$ and $V_{BE3}-V_{BC}{\cong}0.1V$, then

$$V_{th}{\cong}1.5V$$

In addition, the low-level of the output $O_A$ equals the collector-emitter voltage $V_{CE}$ of the transistor $Q_4$, that is, about 0.1V, while the high-level of the output $O_A$ equals $V_{CC}-2V_{BE}$, that is, about 3.5V, when $V_{CC}=5V$.

On the other hand, in the internal logic gate IG, the threshold voltage $V_{th}$ is represented by

$$V_{th}=V_{BC}+V_{BE1}-V_{BE2}$$

where $V_{BC}$ is the base to collector voltage of the transistor $Q_{21}$, $V_{BE1}$ is the base to emitter voltage of the transistor $Q_{22}$, and $V_{BE}$ is the base to emitter voltage of the transistor $Q_{21}$. If it is assumed that

$$V_{BE2}-V_{BC}{\cong}0.1V$$
and
$$=V_{BE1}=V_{BE2}{\cong}V_{BE}{\cong}0.82V,$$

then $V_{th}{\cong}0.7V$. In addition, the low-level of the output $V_0$ is the collector to emitter voltage $V_{CE}$ $({\cong}0.1V)$ of the transistor $Q_{22}$ while the high-level of the output $V_0$ is clamped by the clamp circuit formed by the diode $D_2$ and the resistor $R_8$.

In Fig. 5, in order to match the buffer pattern $G_A$ to the internal logic gate IG, the high-level of the output $V_0$ of the gate IG should be higher than the threshold voltage $V_{th}$ $({\cong}1.5V)$ of the buffer pattern $G_A$. Therefore, it is desirable to enlarge the amplitude of the output $V_0$ by cutting the clamp circuit away, which can be disadvantageous in respect to operation speed.

In Fig. 6, the buffer pattern $G_A'$ of Fig. 3 is connected to the internal logic gate IG. In the buffer pattern $G_A'$, the threshold voltage $V_{th}$ of the input I, is represented by:

$$V_{th}=V_{BE1}+V_{BE2}-V_{BE3}$$

where $V_{BE1}$ is the base to emitter voltage of the transistor $Q_2$, $V_{BE2}$ is the base to emitter voltage of the transistor $Q_4$, and $V_{BE3}$ is the base to emitter voltage of the transistor $Q_{11}$. If it is assumed that

$$V_{BE1}=V_{BE2}=V_{BE3}{\cong}V_{BE},$$

then $V_{th}{\cong}V_{BE}{\cong}0.8V$, which is half of the threshold voltage of the prior art.

In the internal logic gate IG, the high-level of the output $V_0$ is clamped by a series circuit of the two diodes $D_2$ and $D_3$ at about 1.5V since the forward voltage of each diode is equal to or smaller than 0.8V. Therefore, the swing or amplitude of the output $V_0$ is about 0.1 to 1.5V. In addition, when one of the diodes $D_2$ and $D_3$ is constructed as a Schottky barrier diode, the amplitude of the output $V_0$ is about 0.1 to 1.2V. In this case, the threshold voltage of the buffer pattern $G_A'$ is approximately an intermediate value of the amplitude of the output $V_0$, which voltage reasonably drives the buffer pattern $G_A'$.

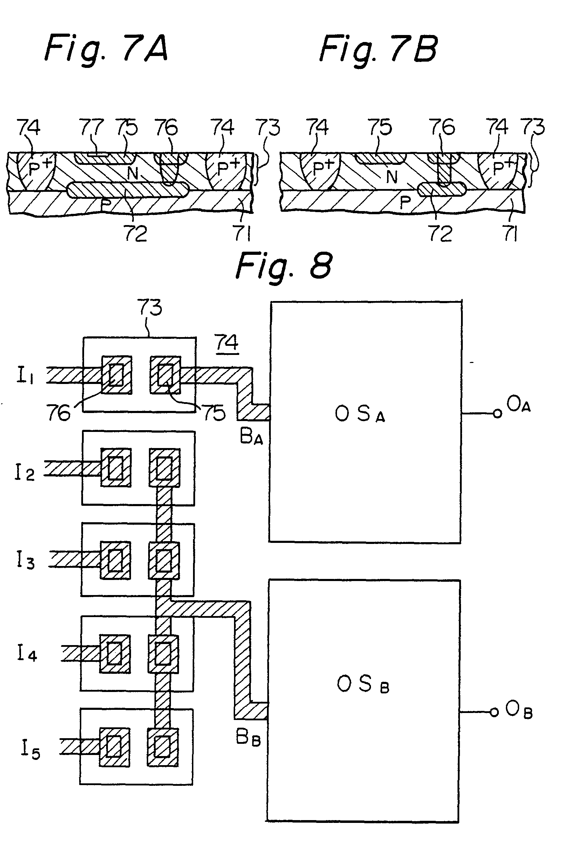

In a structure embodying the present invention, there are two kinds of transistors, that is, NPN transistors and PNP transistors. Such two kinds of transistors are formed in a semiconductor device. For example, in Figs. 7A and 7B, reference numeral 71 designates a semiconductor substrate lightly doped with N-type impurities. An $N^+$-type buried layer 72 having a high concentration is formed on the substrate 71, and, in addition, an N-type epitaxial layer 73 is deposited thereon. Within the epitaxial layer 73 are formed a $P^+$-type impurity diffusion layer 74, a $P^+$-type impurity diffusion layer 75, an $N^+$-type impurity diffusion layer 76, and an $N^+$-type impurity diffusion layer 77. In Fig. 7A, the layers 77, 75, and 73 are an emitter region, a base region, and a collector region, respectively, of an NPN transistor while in Fig. 7B, the layers 75 and 73 and the substrate 71 are an emitter region, a base region, and a collector region, respectively of a PNP transistor. Note that the collector region of the PNP transistor of Fig. 7B can be commonly grounded by grounding the substrate 71. In addition, in Fig. 7B, the buried layer 72 is small; however, the buried layer 72 can be omitted. Further, in Fig. 7B, the base width is large so that the value $h_{FE}$ is small; however, such a small value $h_{FE}$ is sufficient for a buffer.

In the circuit of Fig. 8, a custom-made layout pattern (interconnections) is illustrated by the shaded portions. the circuit of Fig. 8 corresponds to that of Fig. 4A.

In embodiments of the present invention, since the input stage of a buffer is constructed as single-emitter PNP transistors which are prepared without connections, the input stage of each buffer is voluntarily altered by a custom-made layout pattern and thereby the buffer can be better utilized. In addition, the input threshold voltage of each buffer can be small, and therefore suitable for a high speed LSI semiconductor circuit having a small amplitude.

**Claims**

1. A masterslice integrated circuit device including a plurality of input and output logic gates disposed in a peripheral region thereof, a plurality of internal logic gates disposed in a central region thereof, and a desired wiring pattern connecting said logic gates to provide desired circuit functions, said logic gates being arranged in the form of an array, at least one of said logic gates comprising:

a plurality of PNP transistors ($Q_{11} \sim Q_{15}$), each of said PNP transistors having a base for receiving a first signal and an emitter for providing a second signal corresponding to said first signal; and

a plurality of output stage circuits ($OS_A$, $OS_B$) which are arranged at positions so that at least one of said PNP transistors can be connected to one of said output stage circuits by said desired wiring pattern, one of said output stage circuits being connected to the emitter of at least one of said plurality of PNP transistors to form one of said logic gates.

2. A device as set forth in claim 1, wherein each of said output stage circuits includes:

first and second power supply terminals (GND, $V_{CC}$);

a first NPN transistor ($Q_2$) having a base connected to the emitter of at least one of said plurality of PNP transistors, a collector connected to said second power supply terminal; and an emitter;

a second NPN transistor ($Q_3$) having a base connected to the collector of said first NPN transistor, a collector connected to said second power supply terminal, and an emitter; and

a third NPN transistor ($Q_4$) having a base connected to the emitter of said first NPN transistor, a collector connected to the emitter of said second NPN transistor and serving as one output, and an emitter connected to said first power supply terminal.

3. A device as set forth in claim 2, wherein each of said output stage circuits further includes a diode ($D_1$) having an anode connected to the emitter of said second NPN transistor and a cathode connected to the collector of said second NPN transistor.

4. A method for manufacturing a masterslice integrated circuit device including a plurality of input and output logic gates disposed in a peripheral region thereof, a plurality of internal logic gates disposed in a central region thereof, and a desired wiring pattern disposed between said logic gates to provide desired circuit functions, said logic gates being arranged in the form of an array, said method comprising the steps of:

forming a plurality of PNP transistors, each of said PNP transistors having a base for receiving a first signal and an emitter for providing a second signal corresponding to said first signal;

forming a plurality of output stage circuits at positions so that at least one of said PNP transistors can be connected to one of said output stage circuits, each of said plurality of output stage circuits having an input and an output terminals; and

electrically connecting the emitter of at least one of said plurality of PNP transistors to the input terminal of one of said plurality of output stage circuits to form one of said logic gates, using the said desired wiring pattern.

**Patentansprüche**

1. Integrierte Schaltungsvorrichtung in Hauptscheibentechnik mit einer Vielzahl von Eingangs- und Ausgangs-Logikgates, die in einem peripheren Bereich derselben angeordnet sind, einer Vielzahl von internen Logikgates, die in einem zentralen Bereich derselben angeordnet sind, und einem gewünschten Verdrahtungsmuster, welches die genannten Logikgates verbindet, um die gewünschten Schaltungsfunktionen zu liefern, wobei die genannten Logikgates in Form eines Array angeordnet sind und wenigstens eines der Logikgates umfaßt:

eine Vielzahl von PNP-Transistoren ($Q_{11} \infty Q_{15}$), wobei jeder der genannten PNP-Transistoren eine Basis hat, um ein erstes Signal zu empfangen, und einen Emitter, um ein zweites Signal zu liefern, welches dem genannten ersten Signal entspricht; und

eine Vielzahl von Ausgangsstufenschaltungen ($OS_A$, $OS_B$), die an Positionen so angeordnet sind, daß wenigstens einer der genannten PNP-Transistoren mit einer der genannten Ausgangsstufenschaltungen durch das genannten gewünschte Verdrahtungsmuster verbunden werden kann, und eine der genannten Ausgangsstufenschaltungen mit dem Emitter des wenigstens einen der genannten Vielzahl von PNP-Transistoren verbunden ist, um eines der genannten Logikgates zu bilden.

2. Vorrichtung nach Anspruch 1, bei der jede der genannten Ausgangsstufenschaltungen umfaßt:

erste und zweite Energieversorgungsanschlüsse (GND, $V_{cc}$);

einen ersten NPN-Transistor ($Q_2$), der eine Basis, die mit dem Emitter von wenigstens einem der genannten Vielzahl von PNP-Transistoren verbunden ist, einen Kollektor, der mit dem genannten zweiten Energieversorgungsanschluß verbunden ist, und einen Emitter hat;

einen zweiten NPN-Transistor ($Q_3$), der eine Basis, die mit dem Kollektor des NPN-Transistors verbunden ist, einen Kollektor, der mit dem genannten zweiten Energieversorgungsanschluß verbunden ist, und einen Emitter hat; und

einen dritten NPN-Transistor ($Q_4$), der eine Basis, die mit dem Emitter des genannten ersten NPN-Transistors verbunden ist, einen Kollektor, der mit dem Emitter des genannten zweiten NPN-Transistors verbunden ist und als ein Ausgang dient, und einen Emitter, der mit dem genannten ersten Energieversorgungsanschluß verbunden ist, hat.

3. Vorrichtung nach Anspruch 2, bei der jede der genannten Ausgangsstufenschaltungen ferner eine Diode ($D_1$) umfaßt, die eine Anode hat, die mit dem Emitter des genannten zweiten NPN-Transistors verbunden ist, und eine Kathode, die mit dem Kollektor des genannten NPN-Transistors verbunden ist.

4. Verfahren zur Herstellung einer integrierten Hauptscheiben-Schaltungsvorrichtung, die eine Vielzahl von Eingangs- und Ausgangs-Logikgates, die in einem peripheren Bereich derselben angeordnet sind, eine Vielzahl von internen Logikgates, die in einen zentralen Bereich derselben angeordnet sind, und ein gewünschtes Verdrahtungsmuster umfaßt, das zwischen den genannten Logikgates angeordnet ist, um die gewünschten Schaltungsfunktionen zu liefern, wobei die genannten Logikgates in der Form eines Array angeordnet sind, welches Verfahren die folgenden Schritte umfaßt:

Bilden einer Vielzahl von PNP-Transistoren, von denen jeder PNP-Transistor eine Basis für den Empfang eines ersten Signals und einen Emitter für die Lieferung eines zweiten Signals hat, welches dem genannten ersten Signal entspricht;

Bilden einer Vielzahl von Ausgangsstufenschaltungen an Positionen, so daß wenigstens einer der genannten PNP-Transistoren mit einer der genannten Ausgangsstufenschaltungen verbunden werden kann, und jede der Vielzahl von Ausgangsstufenschaltungen einen Eingangs- und einen Ausgangsanschluß hat; und

elektrisches Verbinden der Emitter von wenigstens einem der genannten Vielzahl von PNP-Transistoren mit dem Eingangsanschluß von einer der genannten Vielzahl von Ausgangsstufenschaltungen, um eines der genannten Logikgates zu bilden, wobei das genannte gewünschte Vordrahtungsmuster verwendet wird.

**Revendications**

1. Dispositif à circuit intégré réalisé à partir d'une matrice standard incluant un ensemble de portes logiques d'entrée et de sortie disposées dans sa région périphérique, un ensemble de portes logiques intérieures disposées dans sa région centrale, et un dessin de câblage voulu connectant les portes logiques pour remplir des fonctions de circuit voulues, les portes logiques étant disposées sous la forme d'un réseau, au moins une des portes logiques comprenant:

un ensemble de transistors PNP ($Q_{11} \infty Q_{15}$), chacun des transistors PNP comportant une base pour recevoir un premier signal et un émetteur pour fournir un deuxième signal correspondant au premier signal; et

un ensemble de circuits d'étage de sortie ($OS_A$, $OS_B$) qui sont disposés à des emplacements tels qu'au moins un des transistors PNP peut être connecté à un des circuits d'étage de sortie par le dessin de câblage voulu, un des circuits d'étage de sortie étant connecté à l'émetteur d'au moins un de l'ensemble des transistors PNP pour former une des portes logiques.

2. Dispositif selon la revendication 1, dans lequel chacun des circuits d'étage de sortie comprend:

des première et deuxième bornes de source de tension d'alimentation (MASSE $V_{cc}$);

un premier transistor (NPN ($Q_2$) comportant une base connectée à l'émetteur d'au moins un de l'ensemble des transistors PNP, un collecteur connecté à la deuxième borne de source de tension d'alimentation; et un émetteur;

un deuxième transistor NPN ($Q_3$) comportant une base connectée au collecteur du premier transistor NPN, un collecteur connecté à la deuxième borne de source de tension d'alimentation, et un émetteur; et

un troisième transistor NPN ($Q_4$) comportant une base connectée à l'émetteur du premier transistor NPN, un collecteur connecté à l'émetteur du deuxième transistor NPN et servant de sortie, et un émetteur connecté à la première borne de source de tension d'alimentation.

3. Dispositif selon la revendication 2, dans lequel chacun des circuits d'étage de sortie comprend en outre une diode (D₁) comportant une anode connectée à l'émetteur du deuxième transistor NPN et une cathode connectée au collecteur du deuxième transistor NPN.

4. Procédé pour fabriquer un dispositif à circuit intégré réalisé à partir d'une matrice standard incluant un ensemble de portes logiques d'entrée et de sortie disposées dans sa région périphériques, un ensemble de porte logiques intérieures disposées dans sa région centrale, et un dessin de câblage voulu disposé entre les portes logiques pour remplir des fonctions de circuit voulues, lss portes logiques étant disposées sous la forme d'une réseau, le procédé consistant à:

former un ensemble de transistor PNP, chacun des transistors PNP comportant une base pour recevoir un premier signal et un émetteur pour fournir un deuxième signal correspondant au premier signal;

former un ensemble de circuits d'étage de sortie à des positions telles qu'au moins un des transistors PNP peut être connecté à un des circuits d'étage de sortie, chacun de l'ensemble des circuits d'étage de sortie comportant une borne d'entrée et une borne de sortie; et à

connecter électriquement l'émetteur d'au moins un de l'ensemble des transistors PNP à la borne d'entrée d'un de l'ensemble des circuits d'étage de sortie pour former une des portes logiques, en utilisant le dessin de câblage voulu.

*Fig. 1*

*Fig. 2*

# Fig. 3

# Fig. 4A

# Fig. 4B

# Fig. 4C

# Fig. 4D

*Fig. 5*

Vth = 0.8V

Vth = 1.5V

*Fig. 6*

Vth = 0.8V

Vth = 0.8V

3

# Fig. 7A

# Fig. 7B

# Fig. 8